# EUROPEAN PATENT APPLICATION

(11) **EP 4 518 601 A1**
(43) Date of publication of application: **05.03.2025**
(21) Application number: 23810818.7
(22) Date of filing: 09.05.2023
(51) Int. Cl.: H05K 7/20

(54) **HEATING MODULE, HEAT DISSIPATION APPARATUS, AND COMMUNICATION DEVICE**

(30) Priority: 24.05.2022 CN 202210576912
(71) Applicant: Huawei Technologies Co., Ltd., Shenzhen, Guangdong 518129 (CN)
(72) Inventor: LI, Xiaodong, Shenzhen, Guangdong 518129 (CN); LIN, Peiqing, Shenzhen, Guangdong 518129 (CN); YAN, Tao, Shenzhen, Guangdong 518129 (CN)
(74) Representative: Gill Jennings & Every LLP
(86) International application number: PCT/CN2023/092973
(87) International publication number: WO 2023/226745

(57) **Abstract**

This application provides a heating module, a heat dissipation apparatus, and a communication device. The heating module includes an enclosure, a first heating component, and a floating cover. The first heating component is disposed in the enclosure, the enclosure has an opening, and the floating cover has a first boss. The first boss can extend into the opening. The floating cover is mounted on the enclosure via a first elastic member, and the first elastic member drives the first boss to apply first pressure to the first heating component. In other words, driven by the first elastic member, the floating cover has a pre-tightening force, so that the first boss is closely attached to the first heating component, thereby improving heat dissipation efficiency of the first heating component, improving heat dissipation efficiency of the entire heating module, and improving a service life of the heating module. The floating cover stably fastens the first heating component to the enclosure, and shaking is not prone to occur. This helps improve fastening reliability of the first heating component, and the first heating component is not prone to be damaged by shaking, to improve the service life of the heating module.

## Description

This application claims priority to Chinese Patent Application No. 202210576912.8, filed with the China National Intellectual Property Administration on May 24, 2022 and entitled "HEATING MODULE, HEAT DISSIPATION APPARATUS, AND COMMUNICATION DEVICE", which is incorporated herein by reference in its entirety.

### TECHNICAL FIELD

This application relates to the field of electronic device technologies, and in particular, to a heating module, a heat dissipation apparatus, and a communication device.

### BACKGROUND

An optical module is an important part of an optical network, and is configured to implement functions of converting an optical signal into an electrical signal and converting an electrical signal into an optical signal, to ensure switching between signals. With an increase of communication network requirements, a capacity of a network electronic device gradually increases, a rate of a backplane of the network electronic device greatly increases, a capacity of a line-side optical module is doubled synchronously, and power consumption of the optical module increases by more than 30%. This is mainly reflected in a sharp increase in power consumption of a digital signal processing (digital signal processing, DSP) chip of the optical module. The increase in the power consumption of the DSP chip makes heat dissipation of the DSP chip difficult.

### SUMMARY

This application provides a heating module, a heat dissipation apparatus, and a communication device, to provide a pre-tightening force for a heating component of the heating module, to improve heat dissipation efficiency of the heating component, so that heat dissipation efficiency of the entire heating module is improved, and a service life of the heating module is improved.

According to a first aspect, this application provides a heating module, where the heating module includes an enclosure, a first heating component, and a floating cover. The first heating component is disposed in the enclosure, the enclosure has an opening, and the floating cover has a first boss. A size of the first boss matches a size of the opening, so that the first boss can extend into the opening. The floating cover is mounted on the enclosure via a first elastic member, and the first elastic member drives the first boss to apply first pressure to the first heating component. In other words, driven by the first elastic member, the floating cover has a pre-tightening force, so that the first boss is closely attached to the first heating component, thereby improving heat dissipation efficiency of the first heating component, improving heat dissipation efficiency of the entire heating module, and improving a service life of the heating module. In addition, the floating cover stably fastens the first heating component to the enclosure, and shaking and other cases are not prone to occur. This helps improve fastening reliability of the first heating component, and the first heating component is not prone to be damaged by shaking. This also helps improve the service life of the heating module.

In addition, the heating module may further include a second heating component. In this case, the enclosure may have a second boss, and the second boss is thermally connected to the second heating component. If the first heating component and the second heating component that are of the heating module are respectively connected to different bosses, tolerances of the two heating components do not need to be considered. When a flexible heat conduction layer is disposed between the second boss and the second heating component, a thickness of the flexible heat conduction layer does not need to be set to be excessively large. This also helps improve a heat dissipation effect of the second heating component.

The heating module further includes at least two first heating components. In this case, the at least two first heating components may be disposed on floating covers of a quantity same as that of the first heating components. The first heating components are disposed in one-to-one correspondence with the floating covers. A first boss of a floating cover applies first pressure to each first heating component. In this solution, if different first bosses apply first pressure to different first heating components, there is no interference between the different first heating components, and tolerances between the different first heating components do not need to be considered. A thickness of a flexible heat conduction layer between the first heating component and the first boss may still be set to be small. In addition, each first heating component has a strong heat dissipation capability. This helps improve the overall heat dissipation efficiency of the heating module and improve the service life of the heating module.

When the floating cover is specifically disposed, the flexible heat conduction layer may be disposed between the first boss and the first heating component. The flexible heat conduction layer may be compressed. Specifically, the flexible heat conduction layer may be deformed in a first direction. The first direction is a direction of the first pressure applied by the first boss to the first heating component. Therefore, tightness of attachment between the first boss and the first heating component can be improved, and heat conduction efficiency can be improved.

In a specific technical solution, the flexible heat conduction layer includes at least one of a carbon fiber heat conduction layer, a highly conductive silicone grease heat conduction layer, or a phase change material heat conduction layer. The flexible heat conduction layer of the foregoing material has a low temperature rise in a heat conducting process. This helps further improve the heat dissipation efficiency of the first heating component.

In addition, a temperature equalizing layer may be further disposed between the first boss and the first heating component. The temperature equalizing layer has a strong heat conduction capability, and can implement a temperature equalizing effect, effectively reduce heat flow density of a high power consumption heat source, and reduce temperature rise of the first boss and a heat sink. This helps improve the heat dissipation efficiency of the first heating component.

In a specific technical solution, the temperature equalizing layer includes at least one of a graphite temperature equalizing layer, a phase change material temperature equalizing layer, and a metal temperature equalizing layer. The temperature equalizing layer of the foregoing material has a strong heat conduction capability. This helps improve the temperature equalizing effect.

When the flexible heat conduction layer and the temperature equalizing layer are disposed in a stacked manner between the first boss and the first heating component, a thickness of the temperature equalizing layer is greater than a thickness of the flexible heat conduction layer. This helps improve a temperature equalizing capability of the temperature equalizing layer.

In addition, when the flexible heat conduction layer and the temperature equalizing layer are disposed in the stacked manner between the first boss and the first heating component, the temperature equalizing layer is located on a side that is of the flexible heat conduction layer and that is away from the first heating component. In other words, the flexible heat conduction layer is in contact with the first heating component. This helps protect the first heating component.

When the first boss is specifically disposed, a specific material of the first boss may be a boss made of a metal material, or may be a boss made of a phase change material, provided that the first boss has good thermal conductivity and sufficient strength.

The heating module in the technical solutions of this application may further include a first heat sink. The first heat sink is mounted on the enclosure via a second elastic member, and the second elastic member drives the first heat sink to apply second pressure to the floating cover. Pressure is applied to the first heating component twice, so that the pressure can be ensured to meet a force requirement of the flexible heat conduction layer, and reliable contact between the first boss and the first heating component and reliable contact between the first heat sink and the floating cover are implemented. This helps perform heat conduction, so that a heat dissipation capability of the heating module is improved.

The second pressure may be specifically greater than the first pressure. This helps ensure that the first heat sink, the floating cover, and the first heating component are closely attached, and improves heat conduction efficiency of a heat conduction path.

The heating module includes the second heating component. The enclosure has the second boss. When the second boss is in contact with the second heating component for connection, the first heat sink may further abut against an area that is of the enclosure and in which the enclosure has the second boss. Overall heat dissipation of the heating module can be implemented via one heat sink. This helps simplify a structure of the heating module.

In another technical solution, the heating module may further include the second heating component and a second heat sink, the enclosure has the second boss, and the second boss is in contact with the second heating component for connection. The second heat sink abuts against the area that is of the enclosure and in which the enclosure has the second boss. This solution can block heat between the first heating component and the second heating component, reduce thermal crosstalk between the two heating components, and help meet a heat dissipation requirement of the second heating component.

In a specific technical solution, the heating module is an optical module, and the first heating component is a chip. The optical module is a common heating module in an electronic device, and a chip of the optical module has a high heat emission amount. Therefore, a good effect is achieved by applying the technical solutions of this application to the optical module.

According to a second aspect, this application further provides a heat dissipation apparatus, where the heating module in the first aspect is mounted on the heat dissipation apparatus. The heat dissipation apparatus specifically includes an accommodating part and a heat sink assembly. The accommodating part has an accommodating cavity for accommodating the heating module, the heating module is inserted into the accommodating cavity, and the heating module may be fastened to the accommodating part. For ease of description, it may be considered that a direction in which the heating module is inserted into the accommodating cavity is a first direction.

The heat sink assembly includes a first heat sink, a support, a sliding assembly, and a linkage part. The support is fastened to the accommodating part, and the first heat sink is connected to the support via the sliding assembly. The accommodating part includes a first side surface and a second side surface that are opposite to each other in a second direction, the first heat sink is located on the first side surface of the accommodating part, and the second side surface is equivalent to a side surface that is of the accommodating part and that is away from a side of the first heat sink. The second direction is perpendicular to the first direction. The sliding assembly includes an oblique groove and a sliding block, and the oblique groove gradually inclines toward the second side surface of the accommodating part in the first direction. Therefore, under guidance of the oblique groove, when moving in the first direction, the first heat sink moves in a direction toward the second side surface, in other words, the first heat sink may move downward obliquely. One end of the linkage part is mounted on the first heat sink, and the other end is located in the accommodating cavity. As the heating module is inserted into the accommodating cavity, the heating module may trigger the linkage part, so that the linkage part drives the first heat sink to move in the first direction. In this case, the sliding block slides relative to the oblique groove, to drive the first heat sink to move toward the second side surface, in other words, drive the first heat sink to move in a direction toward the heating module. When the heating module is completely inserted into the accommodating part, the first heat sink is attached to the heating module. In this solution, when the heating module is not inserted into the accommodating part, a spacing between the first heat sink and the second side surface is large, and may even be greater than a thickness of the heating module in the second direction. Horizontal friction is not prone to be generated between the heating module and a heat dissipation component. In this case, the heating module may be easily inserted into the accommodating part. This reduces operation difficulty in plugging or unplugging the heating module, and facilitates a user in plugging or unplugging the heating module. When the heating module is completely inserted into the accommodating part, the first heat sink and the heating module may be closely attached. This helps reduce a thermal resistance of contact between the first heat sink and the heating module, and improve heat transfer performance between the first heat sink and the heating module.

Specifically, when the heat dissipation apparatus is disposed, a first reset member may be further disposed between the first heat sink and the support. The first reset member has a reset force in the second direction. Specifically, when the heating module is pulled out of the accommodating cavity, the first reset member is configured to drive the first heat sink to move in a direction away from the second side surface. In this solution, under an action of the first reset member, when the heating module is pulled out of the accommodating cavity, the first heat sink may move in the direction away from the second side surface. Specifically, the first heat sink moves along the oblique groove in the direction away from the second side surface, so that the spacing between the first heat sink and the second side surface is large when the heating module is plugged or unplugged, thereby reducing the difficulty of plugging or unplugging the heating module.

In another technical solution, the heat dissipation apparatus may further include a second reset member disposed between the first heat sink and the support. The second reset member has a reset force away from the first direction. Specifically, when the heating module is pulled out of the accommodating cavity, the second reset member is configured to drive the first heat sink to move in a direction opposite to a direction in which the heating module is inserted. In this solution, under an action of the second reset member, when the heating module is pulled out of the accommodating cavity, the first heat sink may move in a direction away from the second side surface. Specifically, the first heat sink moves along the oblique groove in the direction away from the second side surface, so that the spacing between the first heat sink and the second side surface is large when the heating module is plugged or unplugged, thereby reducing the difficulty of plugging or unplugging the heating module.

In a specific embodiment, the heat dissipation apparatus may be provided with only the first reset member or the second reset member, or may be provided with both the first reset member and the second reset member. The first reset member may be of an elastic structure, for example, a spring, an elastic strip, or a spring plate, or may be of a driving structure, for example, a lever that needs to be configured with a driving apparatus. This is not limited in this application. Similarly, the second reset member may also be of an elastic structure, for example, a spring, an elastic strip, or a spring plate, or may be of a driving structure, for example, a lever that needs to be configured with a driving apparatus. This is not limited in this application.

According to a third aspect, this application further provides a communication device. The communication device includes an enclosure and the heating module in the first aspect, and the heating module is mounted on the enclosure. Heat dissipation efficiency of the heating module in this solution is high, so that a heat dissipation effect of the entire communication device can be improved, and a use function life of the communication device can be improved.

In addition, the communication device may further include the heat dissipation apparatus according to the second aspect. The heat dissipation apparatus is mounted on the enclosure, and the heating module is inserted into the heat dissipation apparatus. This reduces operation difficulty in plugging or unplugging the heating module, and facilitates a user in plugging or unplugging the heating module. When the heating module is completely inserted into an accommodating part, a first heat sink and the heating module may be closely attached. This helps reduce a thermal resistance of contact between the first heat sink and the heating module, and improve heat transfer performance between the first heat sink and the heating module.

### BRIEF DESCRIPTION OF DRAWINGS

FIG. 1 is a diagram of a structure of a communication device according to an embodiment of this application;
FIG. 2 is a diagram of a structure of a card according to an embodiment of this application;
FIG. 3 shows a structure of an optical module in a current technology;
FIG. 4 is a diagram of a structure of a heating module according to an embodiment of this application;
FIG. 5 is another diagram of a structure of a heating module according to an embodiment of this application;
FIG. 6 is another diagram of a structure of a heating module according to an embodiment of this application;
FIG. 7 is another diagram of a structure of a heating module according to an embodiment of this application;
FIG. 8 is another diagram of a structure of a heating module according to an embodiment of this application;
FIG. 9 is another diagram of a structure of a heating module according to an embodiment of this application;
FIG. 10 is another diagram of a structure of a heating module according to an embodiment of this application;
FIG. 11 is another diagram of a structure of a heating module according to an embodiment of this application;
FIG. 12 is a diagram of a structure in which a heating module is mounted on a heat dissipation apparatus according to an embodiment of this application; and
FIG. 13 is a diagram of a structure in which a heating module is mounted on a heat dissipation apparatus according to an embodiment of this application.

### Reference numerals:

01-power supply; 02-connector;
03-circuit board; 04-client-side optical module;
05-line-side optical module; 06-chip;
07-central processing unit; 1-heating module;
11-enclosure; 111-boss;
112-bottom plate; 113-side plate;
114-upper cover; 115-opening;
116-second boss; 12-first heating component;
13-second heating component; 14-flexible heat conduction layer;
15-floating cover; 151-cover;
152-first boss; 153-first elastic member;
16-substrate; 17-temperature equalizing layer;
18-heat sink; 181-first heat sink;
1811-second elastic member; 182-second heat sink;
2-heat dissipation apparatus; 21-accommodating part;
211-first side surface; 212-second side surface;
213-accommodating cavity; 22-heat sink assembly;
221-support; 2211-support body;
2212-tail rack; 222-sliding assembly;
2221-oblique groove; 2222-sliding block;
223-linkage part; 23-first reset member; and
24-second reset member.

### DESCRIPTION OF EMBODIMENTS

To make objectives, technical solutions, and advantages of this application clearer, the following further describes this application in detail with reference to accompanying drawings.

Terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment" or "a specific embodiment" or the like described in the specification means that one or more embodiments of this application include a specific feature, structure, or characteristic described with reference to this embodiment. The terms "include", "have", and their variants all mean "include but are not limited to", unless otherwise specifically emphasized in another manner.

To facilitate understanding of a foldable terminal provided in embodiments of this application, the following first describes a possible application scenario of the foldable terminal. Various electronic modules are disposed in a communication device. The electronic module includes a heating module that generates much heat during operation. The heating module generally includes an enclosure and a heating component disposed in the enclosure. For example, the heating module may be an optical module, and the heating component may be a chip disposed in the optical module. To ensure normal operation of the foregoing heating component, a heat sink needs to be used to export heat generated by the heating component. Because the heating component is disposed in the enclosure, the enclosure is usually used to conduct heat, in other words, the enclosure connects the heating component and the heat sink. The following lists embodiments with reference to the accompanying drawings, to clearly describe the technical solutions of this application. In the accompanying drawings of embodiments of this application, an example in which the heating module is the optical module is used for description. In another embodiment, the heating module may alternatively be another module, for example, a chip module. It should be noted that, in embodiments of this application, a same reference numeral represents a same assembly or a same part. For same parts in embodiments of this application, only one part or component marked with a reference numeral may be used as an example in the figure. It should be understood that the reference numeral is also applicable to another same part or component.

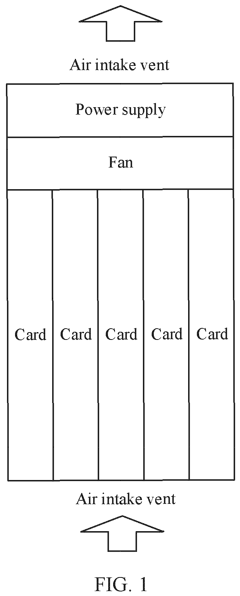

FIG. 1 is a diagram of a structure of a communication device according to an embodiment of this application. Refer to FIG. 1. The communication device usually includes an enclosure and structures such as a card, a fan, and a power supply that are disposed on the enclosure. The card may also be referred to as a board, and mainly includes a circuit board and an electronic component disposed on the circuit board. According to different main functions of the card, the card may specifically include types such as a control card and a service card, where the control card is configured to process an issue related to device running, and the service card is configured to process data. The card may be inserted into a card slot of the enclosure. In the embodiment shown in FIG. 1, the card is a vertically inserted card. In another embodiment, the card may alternatively be a horizontally inserted card. This is not limited in this application. The communication device may be further provided with a backplane (not shown in the figure), and the foregoing card may be connected to the backplane. Specifically, the card and the backplane may each have an adapted connector, and the card and the backplane are connected via connectors. The power supply is configured to supply power to the entire communication device, to ensure normal running of the communication device. The fan is configured to: provide a cooling air volume, and dissipate heat for components in the communication device through an air duct. In the embodiment shown in FIG. 1, the air duct extends roughly in a vertical direction, an air intake vent of the communication device is located at the bottom of the communication device, and an air exhaust vent is located at the top of the communication device. Certainly, in other embodiments, the air duct may alternatively extend roughly in a horizontal direction, an air intake vent of the communication device may be located on a lateral side of the communication device, and an air exhaust vent is located on an opposite side of the air intake vent.

It should be noted that, in the technical solutions of this application, a specific type of the communication device is not limited in this application, and all devices that can perform signal transmission may be referred to as the communication device. For example, the communication device may include a computing device (for example, a server), a network device (for example, a switch), a storage device (for example, a storage array), an in-vehicle device (for example, an in-vehicle sound box or an in-vehicle navigator), or the like, provided that a communication device having a plug-in heating component falls within the protection scope of the technical solutions of this application.

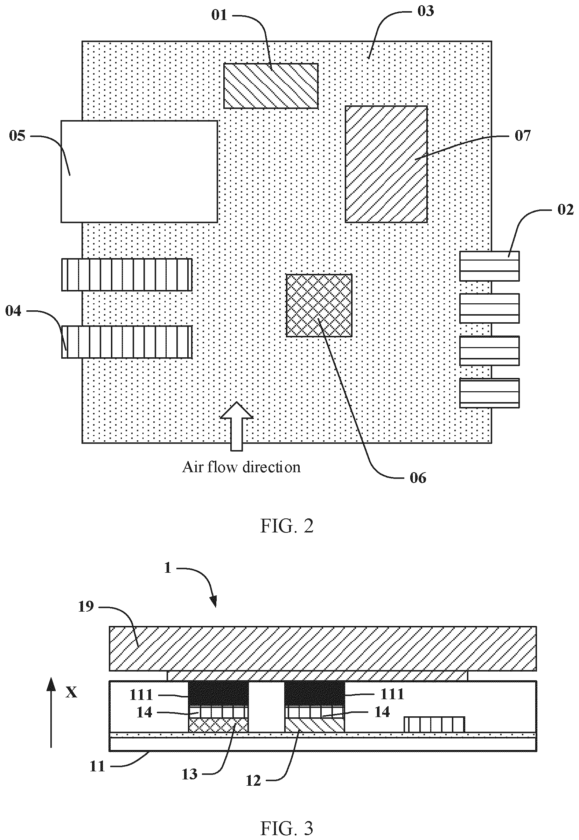

FIG. 2 is a diagram of a structure of a card according to an embodiment of this application. As shown in FIG. 2, the card is usually provided with a heating module, for example, an optical module with high power consumption. The heating module along with the card is mounted on the enclosure, or the heating module may be directly mounted on the enclosure. This is not limited in this application. Specifically, the card may include a power supply 01, a connector 02, a circuit board 03, a client-side optical module 04, a line-side optical module 05, a chip 06, and a central processing unit (central processing unit, CPU) 07. Specifically, the client-side optical module 04 and the line-side optical module 05 perform an optical-electrical conversion function, the chip 06 performs a service processing function, the CPU performs functions such as controlling service receiving and sending, speed adjustment, and emergency processing, and the connector 02 is connected to the backplane and another card or device, to facilitate communication. The client-side optical module 04 is usually a gray optical module (which does not support wavelength division multiplexing), and has a short transmission distance and low module power consumption. The line-side optical module 05 is usually a colored optical module (which supports the wavelength division multiplexing), and has a long transmission distance and high module power consumption. The power consumption of the line-side optical module 05 is high, and therefore a requirement on a heat dissipation capability is also higher. The technical solutions of this application are more important for the line-side optical module 05.

Currently, in a network communication service, the optical module, as an integrated module for mutual conversion between an optical signal and an electrical signal, plays an important role in an optical fiber communication process, and is widely applied. The optical module generates a large amount of heat when used in optical fiber communication. To ensure normal operation of the optical module, the heat generated by the optical module needs to be exported and dissipated in a timely manner. With the development of communication technologies, communication speeds up, service port density increases, and a communication rate of the optical module continuously increases. In addition, the optical module occupies less space, power consumption of the optical module keeps increasing, and the heat generated by the optical module increases. Therefore, the optical module has an increasingly high requirement on heat dissipation.

FIG. 3 is a diagram of a structure of an optical module in the current technology. Refer to FIG. 3. The optical module in the current technology includes an enclosure 11, a first heating component 12, and a second heating component 13, where both the first heating component 12 and the second heating component 13 generate much heat, and a heat sink 18 needs to be used for heat dissipation. Specifically, the first heating component 12 may be a chip, for example, a DSP chip; and the second heating component 13 may be an optical component. The enclosure 11 includes two bosses 111. One boss 111 abuts against the first heating component 12 through a flexible heat conduction layer 14, and the other boss 111 abuts against the second heating component 13 through a flexible heat conduction layer 14. In this way, the heat generated by the first heating component 12 and the second heating component 13 may be conducted to the enclosure 11 through flexible heat conduction layers 14 and the bosses 111, and then the heat sink 18 is attached to the enclosure 11, so that heat dissipation can be performed. In the current technology, because there is a tolerance when the first heating component 12 and the second heating component 13 are mounted, a thickness of the flexible heat conduction layer 14 needs to be set to be large to absorb the tolerance, to ensure that the bosses 111 can be closely attached to the first heating component 12 and the second heating component 13, to improve a heat dissipation effect. Because the flexible heat conduction layer 14 is thick, a temperature rise of the flexible heat conduction layer 14 is large, and heat dissipation efficiency of the first heating component 12 and heat dissipation efficiency of the second heating component 13 are reduced. In addition, in the current technology, pressure between the boss 111 and the first heating component 12 is small. As the optical module shakes, relative displacement is prone to occur between the boss 111 and the first heating component 12. Consequently, the flexible heat conduction layer 14 located between the boss 111 and the first heating component 12 is damaged, and heat dissipation performance of the optical module is reduced.

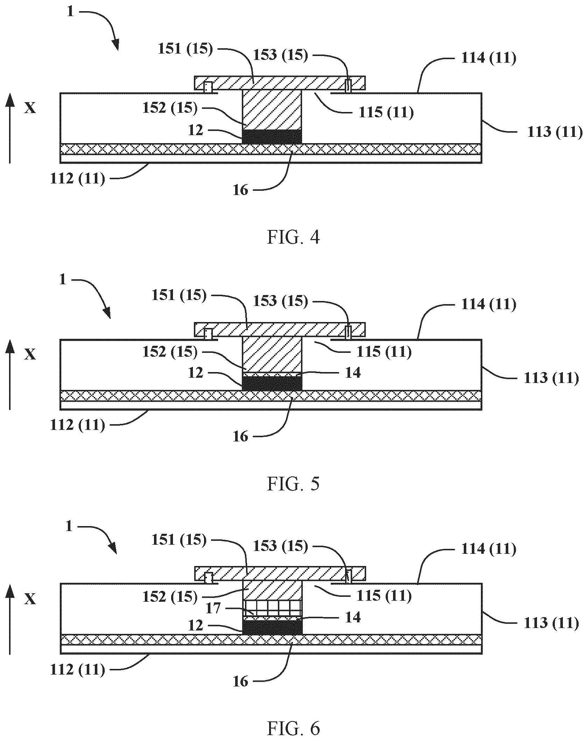

FIG. 4 is a diagram of a structure of a heating module according to an embodiment of this application. Refer to FIG. 4. In an embodiment, the heating module 1 includes an enclosure 11, a first heating component 12, and a floating cover 15. The first heating component 12 is disposed in the enclosure 11. The enclosure 11 may be of an integrated structure, or may be a cavity in which the first heating component 12 is mounted and that is formed by connecting a plurality of components. For example, the enclosure 11 includes a bottom plate 112, a side plate 113, and an upper cover 114. The first heating component 12 is disposed on the bottom plate 112, the side plate 113 is located on a periphery of the first heating component 12, and the upper cover 114 is located on a side that is of the first heating component 12 and that is away from the bottom plate 112. In a specific embodiment, the first heating component 12 may be directly disposed on the bottom plate 112, or the first heating component 12 may be specifically disposed on a substrate 16, and the substrate 16 is further disposed on the bottom plate 112, or the substrate 16 is disposed on the side plate 113, and forms a relatively fixed connection with the bottom plate 112 via the side plate 113. The substrate 16 may be specifically a printed circuit board (printed circuit board, PCB).

Still refer to FIG. 4. The enclosure 11 has an opening 115. Specifically, the opening 115 may be located on the upper cover 114, and is located at a location that is of the enclosure 11 and that is opposite to a surface of the first heating component 12. The floating cover 15 may include a cover 151 and a first boss 152 fastened to the cover 151. The first boss 152 extends into the opening 115 of the enclosure 11 and abuts against the first heating component 12. The floating cover 15 is mounted on the enclosure 11 via a first elastic member 153, and the first elastic member 153 drives the first boss 152 to apply first pressure to the first heating component 12. In this solution, the first elastic member 153 drives the first boss 152 to apply the first pressure to the first heating component 12. The first boss 152 may generate displacement in a first direction X based on an actual situation. The first direction X is perpendicular to a surface that is of the first boss 152 and that is opposite to the first heating component 12. Therefore, a mounting error can be absorbed, so that the first boss 152 is closely attached to the first heating component 12, and heat dissipation efficiency of the first heating component 12 can be improved. In this way, heat dissipation efficiency of the entire heating module 1 is improved, and a service life of the heating module 1 is increased. In addition, the floating cover 15 stably fastens the first heating component 12 to the enclosure 11, and shaking and other cases are not prone to occur. This helps improve fastening reliability of the first heating component 12, and the first heating component 12 is not prone to be damaged by shaking. This also helps improve the service life of the heating module 1.

In a specific embodiment, a specific structure of the first elastic member 153 is not limited. For example, the first elastic member 153 may be an elastic member, for example, a spring screw, a spring plate, or a conical spring.

FIG. 5 is another diagram of a structure of a heating module according to an embodiment of this application. Refer to FIG. 5. A flexible heat conduction layer 14 is further disposed between the first boss 152 and the first heating component 12. The flexible heat conduction layer 14 may be compressed. Specifically, the flexible heat conduction layer 14 may be deformed in the first direction X, so that tightness of attachment between the first boss 152 and the first heating component 12 can be improved, and heat conduction efficiency can be improved. In this embodiment, the first boss 152 applies first pressure to the first heating component 12 under an action of the first elastic member 153. Therefore, the flexible heat conduction layer 14 does not need to absorb a tolerance, and an ultra-thin heat conducting material with a small thickness and a high heat conducting coefficient may be selected to prepare the flexible heat conduction layer 14. In this case, a temperature rise of the flexible heat conduction layer 14 in a heat conducting process is low, and a good heat transferring effect may be achieved, so that heat dissipation efficiency of the first heating component 12 is improved. In this solution, because the first boss 152 is tightly attached to the first heating component 12, the flexible heat conduction layer 14 is stablly fastened between the first boss 152 and the first heating component 12. Even if the heating module 1 vibrates during a transportation process or a production process, relative displacement is not prone to be generated between the first boss 152 and the first heating component 12, so that the flexible heat conduction layer 14 is not prone to be damaged. This helps improve a service life of the flexible heat conduction layer 14, so that the heat dissipation efficiency of the first heating component 12 is more reliable.

In a specific embodiment, a material of the flexible heat conduction layer 14 is not limited. For example, the flexible heat conduction layer 14 may be any one of a carbon fiber heat conduction layer, a highly conductive silicone grease heat conduction layer, or a phase change material heat conduction layer. The flexible heat conduction layer 14 of the foregoing material has a low temperature rise in a heat conducting process. This helps further improve the heat dissipation efficiency of the first heating component 12.

FIG. 6 is another diagram of a structure of a heating module according to an embodiment of this application. Refer to FIG. 6. A temperature equalizing layer 17 may be further disposed between the first boss 152 and the first heating component 12. The temperature equalizing layer 17 has a strong heat conduction capability, and can implement a temperature equalizing effect, effectively reduce heat flow density of a high power consumption heat source, and reduce temperature rises of the first boss 152 and a heat sink 18. This helps improve heat dissipation efficiency of the first heating component 12.

In a specific embodiment, a material of the temperature equalizing layer 17 is not limited. For example, the temperature equalizing layer 17 may be a graphite temperature equalizing layer, a phase change material temperature equalizing layer, or a metal temperature equalizing layer. The metal temperature equalizing layer may specifically include a copper layer, an aluminum layer, or the like. The temperature equalizing layer 17 of the foregoing material has the strong heat conduction capability. This helps improve the temperature equalizing effect.

Still refer to FIG. 6. In an embodiment, when the temperature equalizing layer 17 and the flexible heat conduction layer 14 are included between the first boss 152 of the heating module 1 and the first heating component 12, the temperature equalizing layer 17 and the flexible heat conduction layer 14 are disposed in a stacked manner. A thickness of the temperature equalizing layer 17 is greater than a thickness of the flexible heat conduction layer 14, and this helps improve a temperature equalizing capability of the temperature equalizing layer 17.

In addition, the flexible heat conduction layer 14 is located between the temperature equalizing layer 17 and the first heating component 12. Because the flexible heat conduction layer 14 is flexible, the flexible heat conduction layer 14 is directly in contact with the first heating component 12 to protect the first heating component 12, and this facilitates conduction of heat of the first heating component 12 to the temperature equalizing layer 17 through the flexible heat conduction layer 14. This can improve a heat dissipation capability of the first heating component 12.

When both the flexible heat conduction layer 14 and the temperature equalizing layer 17 are prepared by using phase change materials, the flexible heat conduction layer 14 and the temperature equalizing layer 17 may form an integrated structure. In other words, there is only one phase change material layer between a first protrusion and the first heating component 12, and the phase change material layer can implement effects of both the flexible heat conduction layer 14 and the temperature equalizing layer 17. This solution helps simplify a structure of the heating module 1, and simplify an assembly process of the heating module 1.

When the floating cover 15 is specifically disposed, the cover 151 and the first boss 152 of the floating cover 15 may be of an integrated structure. This helps prepare the floating cover 15. In addition, heat conduction efficiency between the cover 151 and the first boss 152 is high. This helps improve heat dissipation efficiency of the heating module 1. For example, the floating cover 15 may be of an integrated structure of a metal material, and both the cover 151 and the first boss 152 are made of metal materials. In another embodiment, the cover 151 and the first boss 152 of the floating cover 15 may alternatively be of a split structure, and are connected to form the floating cover 15 in a manner of bonding, welding, riveting, thread connection, or the like. This is not limited in this application.

A material of the first boss 152 is not limited in this application. The first boss 152 may be a boss made of a metal material, or may be a boss made of a phase change material, provided that the first boss 152 has good thermal conductivity and sufficient strength. It should be noted that, when the first boss 152 is the boss made of the phase change material, the first boss 152 may be directly in contact with the first heating component 12, and the flexible heat conduction layer 14 or the temperature equalizing layer 17 does not need to be disposed. This is because the phase change material can implement a function of the flexible heat conduction layer 14 or the temperature equalizing layer 17.

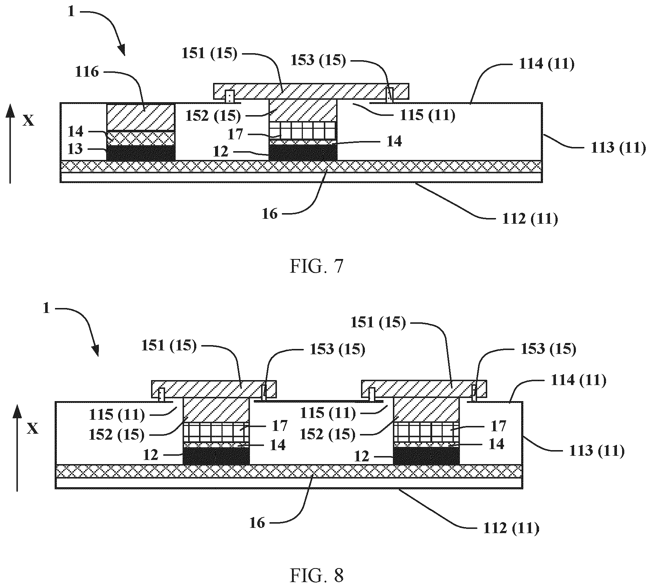

FIG. 7 is another diagram of a structure of a heating module according to an embodiment of this application. Refer to FIG. 7. The heating module 1 further includes a second heating component 13. An enclosure 11 has a second boss 116 opposite to the second heating component 13, and the second boss 116 is connected to the second heating component 13 in a thermally conductive manner. Herein, that the second boss 116 is connected to the second heating component 13 in a thermally conductive manner means: Heat conduction can be performed between the second boss 116 and the second heating component 13. In a specific embodiment, the second boss 116 and the second heating component 13 may be in contact with each other for connection, the flexible heat conduction layer 14 or the temperature equalizing layer 17 may be disposed between the second boss 116 and the second heating component 13, or both the flexible heat conduction layer 14 and the temperature equalizing layer 17 may be disposed between the second boss 116 and the second heating component 13. In this embodiment of this application, if the first heating component 12 and the second heating component 13 of the heating module 1 are respectively connected to different bosses, a tolerance of the two heating components does not need to be considered. When a flexible heat conduction layer 14 is disposed between the second boss 116 and the second heating component 13, a thickness of the flexible heat conduction layer 14 does not need to be set to be excessively large. This helps improve a heat dissipation effect of the second heating component 13.

In a specific embodiment, a temperature specification of the second heating component 13 is lower than a temperature specification of the first heating component 12, in other words, a highest temperature that can be supported when the second heating component 13 operates is lower than a highest temperature that can be supported when the first heating component 12 operates. For example, when the heating module 1 is an optical module, the first heating component 12 may be a chip, and an operating temperature of the first heating component 12 is usually above 100°C; and the second heating component 13 may be an optical component, and an operating temperature of the second heating component 13 is usually below 80°C. In other words, heat generated by the second heating component 13 is lower than heat generated by the first heating component 12. Therefore, the heating component that generates more heat and that is in the heating module 1 dissipates the heat by using the floating cover 15. This can improve an overall heat dissipation capability. In addition, this helps reduce costs and simplify a structure of the heating module 1.

FIG. 8 is another diagram of a structure of a heating module according to an embodiment of this application. Refer to FIG. 8. In still another embodiment, the heating module 1 may include at least two first heating components 12, and the heating module 1 further includes at least two floating covers 15. Specifically, the floating covers 15 are disposed in one-to-one correspondence with the first heating components 12, and a first boss 152 of a floating cover 15 applies first pressure to each first heating component 12. In this solution, if different first bosses 152 apply first pressure to different first heating components 12, there is no interference between the different first heating components, and tolerances between the different first heating components 12 do not need to be considered. A thickness of a flexible heat conduction layer 14 between the first heating component 12 and the first boss 152 may still be set to be small. In addition, each first heating component 12 has a strong heat dissipation capability. This helps improve overall heat dissipation efficiency of the heating module 1 and improve a service life of the heating module 1.

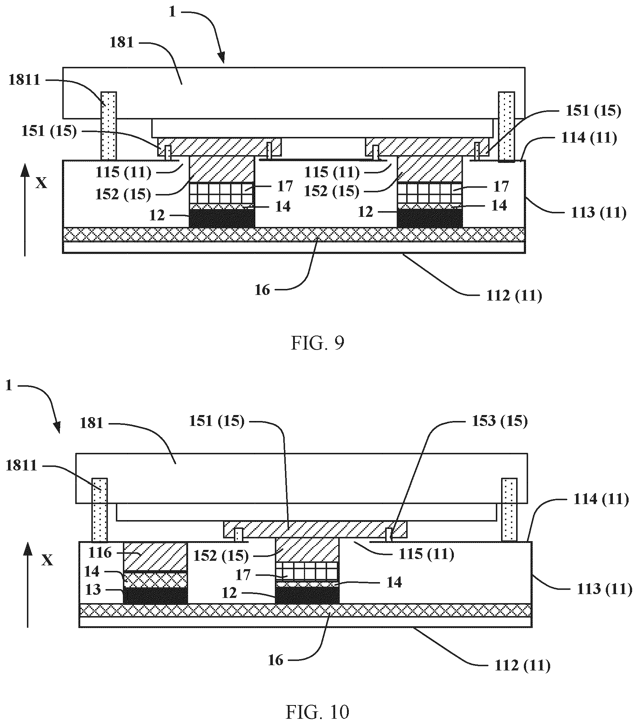

FIG. 9 is another diagram of a structure of a heating module according to an embodiment of this application. Refer to FIG. 9. In still another embodiment, the heating module 1 may further include the first heat sink 181. The first heat sink 181 is mounted on the enclosure 11 via a second elastic member 1811, and the second elastic member 1811 drives the first heat sink 181 to apply second pressure to the floating cover 15. In this solution, pressure may be applied to the first heating component 12 twice, so that the pressure can be ensured to meet a force requirement of the flexible heat conduction layer 14, and reliable contact between the first boss 152 and the first heating component 12 and reliable contact between the first heat sink 181 and the floating cover 15 are implemented. This helps perform heat conduction, so that a heat dissipation capability of the heating module 1 is improved.

In a specific embodiment, a specific structure of the second elastic member 1811 is not limited. For example, the second elastic member 1811 may be an elastic member, for example, a spring screw, a spring plate, or a conical spring.

The second pressure may be specifically greater than the first pressure. This helps ensure that the first heat sink 181, the floating cover 15, and the first heating component 12 are closely attached, and improves heat conduction efficiency of a heat conduction path.

FIG. 10 is another diagram of a structure of a heating module according to an embodiment of this application. Refer to FIG. 10. In still another embodiment, when the heating module 1 includes the second heating component 13, and the enclosure 11 includes the second boss 116, the first heat sink 181 may further abut against an area that is of the enclosure 11 and in which the enclosure 11 has the second boss 116. In this solution, overall heat dissipation of the heating module 1 can be implemented via one heat sink. This helps simplify a structure of the heating module 1.

In this embodiment of this application, the first heat sink 181 may be provided with a heatable pipe and a high heat conduction component to perform temperature equalization, or the opening 115 may be added or a low heat conduction component may be filled to perform heat insulation. Specifically, a local heat dissipation capability may be improved or heat isolation may be performed based on an actual requirement.

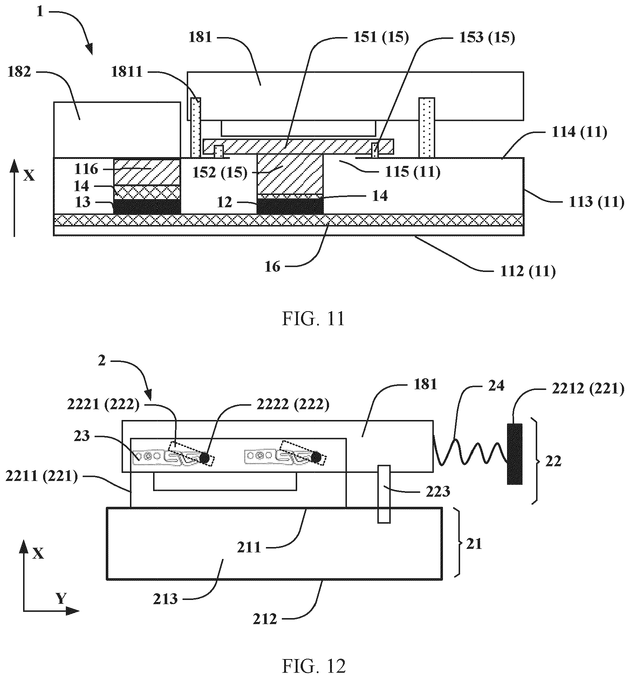

FIG. 11 is another diagram of a structure of a heating module according to an embodiment of this application. Refer to FIG. 11. When the heating module 1 includes the second heating component 13, and the enclosure 11 includes the second boss 116, the heating module 1 may further have a second heat sink 182, and the second heat sink 182 abuts against an area that is of the enclosure 11 and in which the enclosure 11 has the second boss 116. The second heat sink 182 may be directly fastened to the enclosure 11, for example, connected in a manner of an integrated molding process, bonding, welding, riveting, buckle connection, elastic member connection, or thread connection. In this solution, the first heating component 12 dissipates heat by using the first heat sink 181, and the second heating component 13 dissipates heat by using the second heat sink 182, so that heat between the first heating component 12 and the second heating component 13 can be blocked, thermal crosstalk between the two heating components is reduced, and a heat dissipation requirement of the second heating component 13 can be met.

In another embodiment, the first heat sink 181 may be further disposed in a heat dissipation apparatus 2, and the heating module 1 is assembled in the heat dissipation apparatus 2, so that the first heat sink 181 may be used to dissipate heat for the heating module 1. For example, when the heating module 1 is an optical module, the heat dissipation apparatus 2 may be an optical cage. After the optical module is inserted into the optical cage, the first heat sink 181 is attached to the floating cover 15, to implement a heat dissipation function. The following describes the foregoing heat dissipation apparatus 2 in a specific embodiment. The heat dissipation apparatus 2 may be specifically mounted on an enclosure of a communication device, and the heating module 1 is inserted into the heat dissipation apparatus 2.

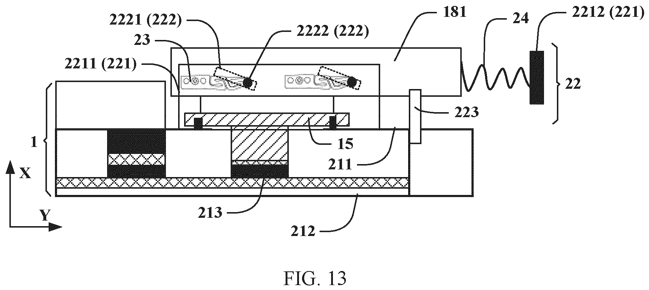

FIG. 12 is a diagram of a structure in which a heating module is mounted on a heat dissipation apparatus according to an embodiment of this application. FIG. 13 is a diagram of a structure in which a heating module is mounted on a heat dissipation apparatus according to an embodiment of this application. Refer to FIG. 12 and FIG. 13. The heating module 1 in the foregoing embodiment is mounted on the heat dissipation apparatus 2 in embodiments of this application, and the heat dissipation apparatus 2 is configured to dissipate heat for the heating module 1. Specifically, the heating module 1 is inserted into the heat dissipation apparatus 2. The heat dissipation apparatus 2 includes an accommodating part 21 and a heat sink assembly 22. The accommodating part 21 includes an accommodating cavity configured to accommodate the heating module 1, and the heating module 1 is inserted into the accommodating cavity in a second direction Y. In other words, the second direction Y mentioned in this embodiment of this application is an insertion direction of the heating module 1. The accommodating part 21 may be specifically of a structure, for example, a card slot, a slot, or an accommodating groove. This is not limited in this application.

As shown in FIG. 13, the heat sink assembly 22 includes the first heat sink 181, a support 221, a sliding assembly 222, and a linkage part 223. The first heat sink 181 is slidably connected to the support 221 via the sliding assembly 222, and the support 221 is fastened to the accommodating part 21, so that the first heat sink 181 can dissipate heat for the heating module 1. The accommodating part 21 includes a first side surface 211 and a second side surface 212 that are opposite to each other in the first direction X, the first heat sink 181 is located on the first side surface 211, and the first direction X is perpendicular to the second direction Y. It is noted that the first side surface 211 and the second side surface 212 are not necessarily specific structures, and mainly refer to a position relationship herein. In other words, in the first direction X, a side that is of the accommodating part 21 and that faces the first heat sink 181 is the first side surface 211, a side that is away from the first heat sink 181 is the second side surface 212, and the heating module 1 may be located between the first side surface 211 and the second side surface 212. In a state shown in FIG. 13, the second side surface 212 may be understood as a bottom surface of the accommodating part 21, and the first side surface 211 may be understood as a top surface of the accommodating part 21. Specifically, the sliding assembly 222 includes an oblique groove 2221 and a sliding block 2222. The sliding block 2222 and the oblique groove 2221 are adaptive to each other, and are slidably connected. In other words, the sliding block 2222 may slide in the oblique groove 2221 relative to the oblique groove 2221, and drive the first heat sink 181 to move in an extension direction of the oblique groove 2221 relative to the support 221. When the oblique groove 2221 is specifically disposed, the oblique groove 2221 gradually inclines toward the second side surface 212 in the second direction Y. In other words, the oblique groove 2221 tilts downward in an insertion direction of the heating module 1. In this case, when the sliding block 2222 slides in the second direction Y in the oblique groove 2221, the first heat sink 181 may move toward the second side surface 212, and gradually approach the heating module 1 located inside the accommodating part 21.

One end of the linkage part 223 of the heat sink assembly 22 is mounted on the first heat sink 181, and the other end is located in an accommodating cavity 213. When the heating module 1 is inserted into the accommodating cavity 213, the linkage part 223 is triggered. The linkage part 223 drives the first heat sink 181 to move in the second direction Y, so that the sliding block 2222 and the oblique groove 2221 of the sliding assembly 222 slide relative to each other. The first heat sink 181 is driven to move toward the second side surface 212, and the first heat sink 181 gradually approaches the heating module 1 located in the accommodating part 21. A structure and a size of the linkage part 223 are properly disposed, so that when the heating module 1 is completely inserted into the accommodating part 21, the first heat sink 181 is attached to the floating cover 15 of the heating module 1, and the second pressure is applied to the floating cover 15.

In the technical solutions of this application, the heat dissipation apparatus 2 may guide a movement of the first heat sink 181 via the oblique groove 2221, and disposal of the linkage part 223 may cause the first heat sink 181 to move with insertion of the heating module 1. In this way, in a process of inserting the first heat sink 181, the linkage part 223 drives the first heat sink 181 to move, and the first heat sink 181 moves downward in an oblique direction under guidance of the oblique groove 2221. In other words, when the heating module 1 is just inserted into the accommodating part 21, there is a spacing (or a small friction force) between the first heat sink 181 and the heating module 1. As the heating module 1 is inserted, the spacing between the first heat sink 181 and the heating module 1 becomes smaller until the first heat sink 181 is in contact with the heating module 1. Therefore, in this solution, a sliding friction force between the heating module 1 and the first heat sink 181 in a movement process can be reduced, so that plugging or unplugging is more effort-saving and convenient. In addition, in this solution, there is no need to consider a problem that the heating module 1 cannot be inserted into the accommodating part 21, or that the heating module 1 is damaged due to a large friction force in an insertion process of the heating module 1. In this way, the first heat sink 181 can move downward with insertion of the heating module 1, and the first heat sink 181 is attached to the heating module 1 under large pressure with the use of both the sliding assembly 222 and the linkage part 223. In this way, the first heat sink 181 closely abuts against, is closely attached to, or in close contact with a surface of the heating module 1, so that a thermal resistance of contact between the first heat sink 181 and the heating module 1 can be reduced, heat transfer performance between the first heat sink 181 and the heating module 1 can be improved, a heat dissipation capability can be improved, and a heat dissipation effect of the heating module 1 can be improved.

In the heat dissipation apparatus 2, the support 221, the sliding assembly 222, and the linkage part 223 are disposed in collaboration with each other, so that the first heat sink 181 can be in close contact with the surface of the heating module 1. This effectively reduces the thermal resistance of the contact between the first heat sink 181 and the heating module 1, improves the heat transfer performance between the first heat sink 181 and the heating module 1, and more effectively dissipates heat for the heating module 1. In addition, in a process of plugging or unplugging the heating module 1, there is no sliding friction movement on a thermally conductive attachment surface between the first heat sink 181 and the heating module 1, the plugging or unplugging is smooth and effort-saving, and contact pressure is stable and controllable.

When the sliding assembly 222 is specifically disposed, in an embodiment, the oblique groove 2221 may be disposed on the first heat sink 181, and the sliding block 2222 may be disposed on the support 221. Alternatively, in another embodiment, the oblique groove 2221 may be disposed on the support 221, and the sliding block 2222 may be disposed on the first heat sink 181. In conclusion, one of the oblique groove 2221 and the sliding block 2222 is disposed on the first heat sink 181, and the other is disposed on the support 221, provided that the first heat sink 181 can move obliquely through a sliding connection between the oblique groove 2221 and the sliding block 2222 that are of the sliding assembly 222. Specific disposal locations of the oblique groove 2221 and the sliding block 2222 are not limited in this application.

Still refer to FIG. 13. The heat dissipation apparatus 2 may further include a first reset member 23. The first reset member 23 is disposed between the first heat sink 181 and the support 221. When the heating module 1 is pulled out of the accommodating cavity 213, the first reset member 23 is configured to drive the first heat sink 181 to move in a direction away from the second side surface 212. In other words, the first reset member 23 may provide the first heat sink 181 with a force in the direction away from the second side surface 212 in the first direction X. The first reset member 23 can drive the first heat sink 181 to move in a direction of moving away from the heating module 1 in the first direction X, and causes the sliding block 2222 to slide relative to the oblique groove 2221. When the heating module 1 is not inserted into the accommodating part 21, there is a spacing between the first heat sink 181 and the second side surface 212, so that the heating module 1 can be smoothly inserted into the accommodating part 21. When the heating module 1 is pulled out of the accommodating part 21, the first reset member 23 drives the first heat sink 181 to be separated from the heating module 1, so that the heating module 1 can be smoothly pulled out of the accommodating part 21.

In a specific embodiment, the first reset member 23 may be an elastic member, for example, a spring or a spring plate. When the heating module 1 is completely inserted into the accommodating part 21, the elastic member is in an energy storage state. When the heating module 1 is pulled out of the accommodating part 21, the elastic member releases energy, and drives the heating module 1 to move in the direction away from the second side surface 212. A structure of the first reset member 23 in this solution is simple. Certainly, in other embodiments, the first reset member 23 may alternatively be a structure, for example, a lever, which is not enumerated herein.

In addition, still refer to FIG. 13. The heat dissipation apparatus 2 may further include a second reset member 24. The second reset member 24 is disposed between the first heat sink 181 and the support 221. When the heating module 1 is pulled out of the accommodating cavity 213, the second reset member 24 is configured to drive the first heat sink 181 to move opposite to the second direction Y. In other words, the second reset member 24 may provide the first heat sink 181 with a force in a direction in which the heating module 1 is pulled out. The second reset member 24 drives the first heat sink 181 to move in the direction in which the heating module 1 is pulled out, and causes the sliding block 2222 to slide relative to the oblique groove 2221. When the heating module 1 is not inserted into the accommodating part 21, there is the spacing between the first heat sink 181 and the second side surface 212, so that the heating module 1 can be smoothly inserted into the accommodating part 21. When the heating module 1 is pulled out of the accommodating part 21, the second reset member 24 drives the first heat sink 181 to be separated from the heating module 1, so that the heating module 1 can be smoothly pulled out of the accommodating part 21.

In a specific embodiment, the support 221 includes a support body 2211 and a tail rack 2212. The sliding assembly 222 is connected between the support body 2211 and the first heat sink 181. The second reset member 24 is connected between the first heat sink 181 and the tail rack 2212. This is not limited in this application. Specifically, the tail rack 2212 and the support body 2211 may be of an integrated structure, or the tail rack 2212 may be fastened to the support body 2211. For example, in the embodiment shown in FIG. 12, the tail rack 2212 is fastened to the support body 2211. For example, the tail rack 2212 may be fastened to the support body 2211 in a manner of welding, riveting, clamping, or threaded connection. Alternatively, the tail rack 2212 and the support body 2211 may be of a split structure, and the tail rack 2212 may be fastened to the accommodating part 21. Certainly, the tail rack 2212 may alternatively be fastened to the support body 2211 in a manner of welding, riveting, clamping, threaded connection, or the like.

In a specific embodiment, the second reset member 24 may be an elastic member, for example, a spring or a spring plate. When the heating module 1 is completely inserted into the accommodating part 21, the elastic member is in an energy storage state. When the heating module 1 is pulled out of the accommodating part 21, the elastic member releases energy, and drives the heating module 1 to move in the direction away from the second side surface 212. A structure of the second reset member 24 in this solution is simple. In other embodiments, the second reset member 24 may alternatively be a structure, for example, a lever, which is not enumerated herein.

To verify a heat dissipation capability of the optical module in embodiments of this application, an inventor of this application performs a comparison experiment by using the card shown in FIG. 2. Specifically, the card includes two 5 W client-side optical modules and one 80 W line-side optical module. The line-side optical module includes a DSP chip whose power consumption is 50 W, namely, the first heating component 12 in embodiments of this application, and further includes an optical component whose power consumption is 5 W. A height of a slot in which the card is mounted is 1.3 inches, and a wind speed of the heat sink is 3 m/s. In this application, heat dissipation capabilities of line-side optical modules are analyzed. Specifically, a conventional heat dissipation solution of an optical module in comparative embodiment is shown in FIG. 3, and a heat dissipation solution of an optical module in this solution is shown in FIG. 13. The following table lists comparison results.

| Heating component | Operating temperature in Comparative embodiment/°C | Operating temperature in this solution/°C | Optimized benefit/°C |
|---|---|---|---|
| DSP chip | 105.8 | 99.5 | -6.3 |
| Optical component | 78.5 | 73.5 | -5 |

It can be seen from the foregoing table that, by using the technical solutions in the current technology, the operating temperature of the chip is 105.8°C, and the operating temperature of the optical component is 78.5°C. When the technical solutions of this application are used, the operating temperature of the chip is 99.5°C, and the temperature decreases by 6.3°C; and the operating temperature of the optical component is 73.5°C, and the temperature decreases by 5°C. The technical solutions of this application have good benefits. This reduces an operating temperature of a heating component, and improves a heat dissipation effect of the heating component.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heating module, comprising an enclosure, a first heating component, and a floating cover, wherein
the first heating component is disposed in the enclosure, the enclosure has an opening, and the floating cover has a first boss; and the floating cover is mounted on the enclosure via a first elastic member, the first boss extends into the opening, and the first elastic member drives the first boss to apply first pressure to the first heating component.

2. The heating module according to claim 1, further comprising a second heating component, wherein the enclosure has a second boss, and the second boss is thermally connected to the second heating component.

3. The heating module according to claim 1 or 2, comprising at least two first heating components, and floating covers that are disposed in one-to-one correspondence with the at least two first heating components.

4. The heating module according to any one of claims 1 to 3, wherein a flexible heat conduction layer is disposed between the first boss and the first heating component.

5. The heating module according to claim 4, wherein the flexible heat conduction layer comprises a carbon fiber heat conduction layer, a highly conductive silicone grease heat conduction layer, or a phase change material heat conduction layer.

6. The heating module according to any one of claims 1 to 5, wherein a temperature equalizing layer is disposed between the first boss and the first heating component.

7. The heating module according to claim 6, wherein the temperature equalizing layer comprises a graphite temperature equalizing layer, a phase change material temperature equalizing layer, and a metal temperature equalizing layer.

8. The heating module according to any one of claims 1 to 7, wherein the flexible heat conduction layer and the temperature equalizing layer are disposed in a stacked manner between the first boss and the first heating component, and a thickness of the temperature equalizing layer is greater than a thickness of the flexible heat conduction layer.

9. The heating module according to any one of claims 1 to 8, wherein the flexible heat conduction layer and the temperature equalizing layer are disposed in the stacked manner between the first boss and the first heating component, and the temperature equalizing layer is located on a side that is of the flexible heat conduction layer and that is away from the first heating component.

10. The heating module according to any one of claims 1 to 9, wherein the first boss is a boss of a metal material or a boss of a phase change material.

11. The heating module according to any one of claims 1 to 10, further comprising a first heat sink, wherein the first heat sink is mounted on the enclosure via a second elastic member, and the second elastic member drives the first heat sink to apply second pressure to the floating cover.

12. The heating module according to claim 11, further comprising the second heating component, wherein the enclosure has the second boss, and the second boss is in contact with the second heating component for connection; and the first heat sink further abuts against an area that is of the enclosure and in which the enclosure has the second boss.

13. The heating module according to claim 12, further comprising the second heating component and a second heat sink, wherein the enclosure has the second boss, and the second boss is in contact with the second heating component for connection; and the second heat sink abuts against the area that is of the enclosure and in which the enclosure has the second boss.

14. The heating module according to any one of claims 11 to 13, wherein the second pressure is greater than the first pressure.

15. The heating module according to any one of claims 1 to 14, wherein the heating module is an optical module, and the first heating component is a chip.

16. A heat dissipation apparatus, on which the heating module according to any one of claims 1 to 15 is mounted, and comprising an accommodating part and a heat sink assembly, wherein
the accommodating part has an accommodating cavity configured to accommodate the heating module, and the heating module is inserted into the accommodating cavity in a first direction;
the heat sink assembly comprises a first heat sink, a support, a sliding assembly, and a linkage part, wherein the support is fastened to the accommodating part, the first heat sink is slidably connected to the support via the sliding assembly, and the sliding assembly comprises an oblique groove and a sliding block that are adaptive to each other, wherein the oblique groove is disposed on the first heat sink and the sliding block is disposed on the support, or the oblique groove is disposed on the support and the sliding block is disposed on the first heat sink; one end of the linkage part is mounted on the first heat sink, and the other end is located in the accommodating cavity; the accommodating cavity comprises a first side surface and a second side surface that are opposite to each other in a second direction, the first heat sink is located on the first side surface, and the oblique groove gradually inclines toward the second side surface in the first direction; and the second direction is perpendicular to the first direction; and
when the heating module is inserted into the accommodating cavity, the linkage part is triggered to drive the first heat sink to move in the first direction, the sliding block slides relative to the oblique groove, and the first heat sink is driven to move toward the second side surface; and when the heating module is completely inserted into the accommodating part, the first heat sink is attached to the heating module.

17. The heat dissipation apparatus according to claim 16, wherein a first reset member is disposed between the first heat sink and the support; and when the heating module is pulled out of the accommodating cavity, the first reset member is configured to drive the first heat sink to move in a direction away from the second side surface.

18. The heat dissipation apparatus according to claim 16 or 17, wherein a second reset member is further disposed between the first heat sink and the support; and when the heating module is pulled out of the accommodating cavity, the second reset member is configured to drive the first heat sink to move opposite to the first direction.

19. A communication device, comprising an enclosure and the heating module according to any one of claims 1 to 15, wherein the heating module is mounted on the enclosure.

20. The communication device according to claim 19, further comprising the heat dissipation apparatus according to any one of claims 16 to 18, wherein the heat dissipation apparatus is mounted on the enclosure, and a heating component is inserted into the heat dissipation apparatus.
